# EUROPEAN PATENT APPLICATION

(11) **EP 4 404 240 A1**
(43) Date of publication of application: **24.07.2024**
(21) Application number: 22868615.0
(22) Date of filing: 31.03.2022
(51) Int. Cl.: H01L 21/02, H01L 21/683, C23C 16/30, C30B 29/40, C30B 25/18

(54) **METHOD FOR MANUFACTURING SELF-SUPPORTING GALLIUM NITRIDE SUBSTRATE**

(30) Priority: 18.09.2021 CN 202111098433
(71) Applicant: Sino Nitride Semiconductor Co, Ltd, Dongguan, Guangdong 523000 (CN)
(72) Inventor: REN, Junjie, Dongguan, Guangdong 523000 (CN); WANG, Shuai, Dongguan, Guangdong 523000 (CN)
(74) Representative: Tiburzi, Andrea
(86) International application number: PCT/CN2022/084250
(87) International publication number: WO 2023/040237

(57) **Abstract**

The present disclosure provides a method for fabricating a self-supporting gallium nitride substrate, comprising: 1) providing a composite substrate including a sapphire substrate and a gallium nitride film; 2) forming a temporary bonding layer on the gallium nitride film; 3) bonding a transfer substrate to the composite substrate by means of the temporary bonding layer; 4) stripping the sapphire substrate by means of a laser stripping process; 5) performing weak bonding on a receiving substrate and the gallium nitride film, and stripping the transfer substrate from the gallium nitride film by disabling the temporary bonding layer, and 6) epitaxially growing a gallium nitride epitaxial layer on the gallium nitride film, and disabling the weak bonding by means of the lattice mismatch stress and/or the thermal mismatch stress between the gallium nitride film and the gallium nitride epitaxial layer and the receiving substrate, so as to realize separation between the gallium nitride film and the receiving substrate. The present application can effectively overcome the defect that the thickness of a heterojunction gallium nitride epitaxial layer is limited due to lattice mismatch and thermal mismatch, improve the quality of the self-supporting gallium nitride substrate, and reduce the manufacturing cost of the self-supporting gallium nitride substrate.

## Description

### TECHNICAL FIELD

Examples of the present application relate to the field of semiconductor manufacturing, for example, a method for manufacturing a free-standing gallium nitride substrate.

### BACKGROUND

In recent years, the third generation of semiconductor materials represented by gallium nitride (GaN) and its alloy, as new semiconductor materials, have received much attention in the world, which have many excellent properties such as wide band gap, high electron saturation drift velocity, small dielectric constant, good thermal conductivity, stable structure, etc., and have promising application prospects in the technical field of optoelectronics and microelectronics. In the field of optoelectronics, Group III nitride materials can be used to manufacture green, blue and even ultraviolet light-emitting devices and white-light illumination, because its band gap is adjustable from 0.7 eV to 6.2 eV and covers the spectrum from red light to ultraviolet. In addition, the currently emerging ultraviolet LEDs are specially employed in screen printing, polymer curing and environmental protection, greatly arousing the researchers' interest. GaN lasers are useful in information storage, and can also be used in various fields such as medical diagnosis, submarine exploration and communication.

The preparation of GaN single crystal is difficult, and the bulk single crystal of GaN substrate with large size and good quality is hard to obtain, and thus the epitaxial growth of GaN is carried out in a heteroepitaxial manner. However, it is shown by both theories and experiments that the device performance will be significantly improved when homoepitaxially grown on a GaN substrate. Therefore, the manufacture of free-standing GaN substrates is increasingly the focus of attention.

At present, large-area GaN free-standing substrates are usually obtained by growing GaN thick film on a heterogeneous substrate via vapor phase growth and then detaching the heterogeneous substrate. For the manufacture, a sapphire substrate is the most commonly used. In order to obtain the free-standing substrate, the sapphire substrate should be removed. Sapphires have hard texture and stable chemical properties, so it is difficult to remove sapphires by chemical corrosion or mechanical grinding. At present, laser lift-off method is often used to separate GaN and the sapphire substrate. However, the laser lift-off technology is expensive; and in the process of laser lift-off, the prepared GaN free-standing substrate can be easily damaged by the high-pressure gas generated by the high temperature decomposition of GaN at the interface, because of which the GaN free-standing substrate will suffer from problems ranging from a large number of dislocations and microcracks, which subsequently affect the quality of the device, and worst of all, to being completely broken, greatly reducing the yield.

In summary, when the epitaxial growth is carried out on heterogeneous materials, the thickness of heteroepitaxy gallium nitride is limited by the lattice mismatch and thermal mismatch, and besides, the process of detaching gallium nitride single crystas is difficult, especially for large-size sapphire/gallium nitride thick film composite substrate (HVPE primary epitaxial wafer).

### SUMMARY

The following is a summary of the subject described herein. This summary is not intended to limit the protection scope of the claims.

In view of the shortcomings of the related art, an example of the present application provides a method for manufacturing a free-standing gallium nitride substrate, which solves a problem of the thickness limitation of heteroepitaxial gallium nitride caused by large lattice mismatch and thermal mismatch existing between the thick gallium nitride epitaxial layer and the sapphire substrate in the related art.

An example of the present application provides a method for manufacturing a free-standing gallium nitride substrate, and the manufacturing method comprises: (1) providing a composite substrate, wherein the composite substrate comprises a sapphire substrate and a gallium nitride film formed on the sapphire substrate; (2) forming a temporary bonding layer on the gallium nitride film; (3) providing a transfer substrate, and bonding the transfer substrate to the composite substrate by the temporary bonding layer; (4) detaching the sapphire substrate by laser lift-off process to expose the gallium nitride film; (5) providing a receiving substrate, and subjecting the receiving substrate and the gallium nitride film to weak bonding, and invalidating the temporary bonding layer to detach the transfer substrate from the gallium nitride film; and (6) epitaxially growing a gallium nitride epitaxial layer on the gallium nitride film, and after the gallium nitride epitaxial layer grows to a certain thickness, invalidating the weak bonding between the gallium nitride film and the receiving substrate by the lattice mismatch stress and the thermal mismatch stress between the receiving substrate and the gallium nitride film as well as the gallium nitride epitaxial layer, so as to separate the gallium nitride film and the receiving substrate to obtain the free-standing gallium nitride substrate.

Optionally, step (5) comprises: forming a first metal grid on the surface of the receiving substrate, forming a second metal grid on the surface of the gallium nitride film, and stacking the first metal grid and the second metal grid, and then enabling them to diffuse to each other by bonding process to subject the receiving substrate and the gallium nitride film to weak bonding, and meanwhile, invalidating the temporary bonding layer by the bonding process to detach the transfer substrate from the gallium nitride film.

Optionally, a temperature of the bonding process is lower than a melting temperature of the first metal grid and the second metal grid.

Optionally, a material of the first metal grid comprises one of Ti, Cr and Mo, and a material of the second metal grid comprises one of Ti, Cr and Mo.

Optionally, forming the first metal grid on the surface of the receiving substrate comprises: forming a photoresist layer on the surface of the receiving substrate, and forming a grid-grooved photolithographic pattern on the receiving substrate by exposure and development; forming the first metal grid on the surface of the receiving substrate by evaporation deposition and metal lift-off process; forming the second metal grid on the surface of the gallium nitride film comprises: forming a photoresist layer on the surface of the gallium nitride film, and forming a grid-grooved photolithographic pattern on the gallium nitride film by exposure and development; forming the second metal grid on the surface of the gallium nitride film by evaporation deposition and metal lift-off process.

Optionally, the first metal grid has a same shape and size as the second metal grid, and when the receiving substrate is bonded with the gallium nitride film, the first metal grid is aligned with the second metal grid.

Optionally, the temporary bonding layer is formed on the gallium nitride film by spin coating process in step (2), and the temporary bonding layer comprises one of an epoxy resin and a high-temperature wax.

Optionally, a material of the transfer substrate and the receiving substrate comprises one of sapphire, silicon and quartz.

Optionally, step (4) further comprises performing acid pickling on the exposed surface of the gallium nitride film to remove remained metal gallium on the surface of the gallium nitride film.

Optionally, the gallium nitride epitaxial layer is epitaxially grown on the gallium nitride film by hydride vapor phase epitaxy process in step (6).

As described above, the method for manufacturing a free-standing gallium nitride substrate provided by the examples of the present application has the following beneficial effects.

In the examples of the present application, by the receiving substrate and the metal grids, the bonding between the sapphire substrate and the gallium nitride epitaxial layer is changed from the original strong chemical bonding to a weak bonding realized by the metal grids, so that the gallium nitride film is weakly connected to the receiving substrate, thereby weakening the constraint from the lattice of the receiving substrate on the growth of the gallium nitride epitaxial layer during the hydride vapor phase epitaxy process, and the gallium nitride epitaxial layer can grow thicker, and at a certain thickness, the lattice mismatch stress and thermal mismatch stress are used to break the weak connection between the gallium nitride film and the receiving substrate and realize the separation of the gallium nitride film and the receiving substrate. The thick gallium nitride epitaxial layer can be obtained by only one epitaxial growth. The examples of the present application can effectively overcome the shortcomings that the thickness of heteroepitaxial gallium nitride layer is limited due to lattice mismatch and thermal mismatch, improve the quality of the free-standing gallium nitride substrate, and reduce the manufacturing cost of the free-standing gallium nitride substrate.

After reading and understanding the drawings and detailed descriptions, other aspects can be understood.

### BRIEF DESCRIPTION OF DRAWINGS

The drawings are used to provide a further understanding of the technical solutions herein and form part of the specification, which together with examples of the present application explain the technical solutions herein and should not be construed as the limitations of the technical solutions herein.

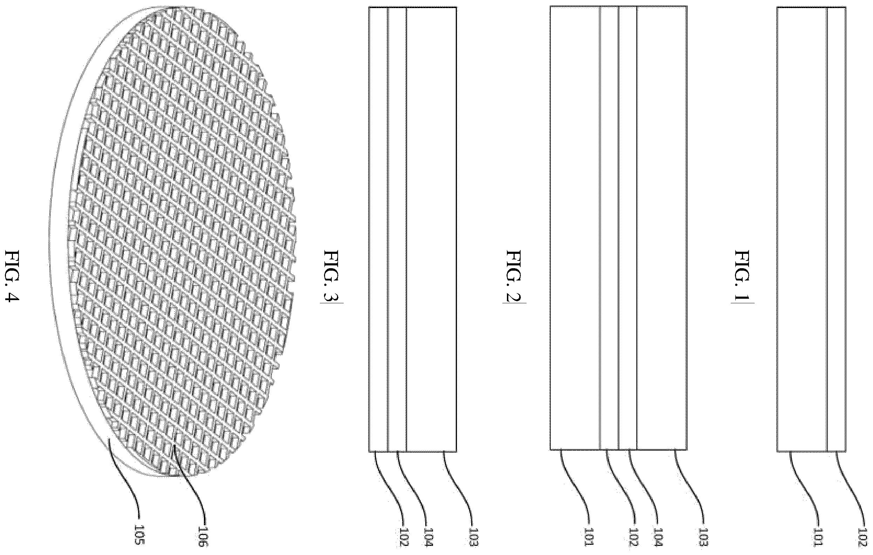

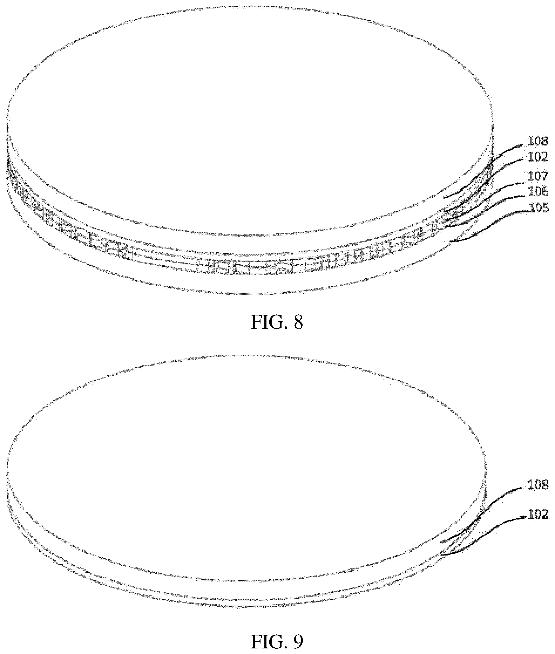

FIGS. 1-9 are structural schematic diagrams from steps of a method for manufacturing a free-standing gallium nitride substrate provided in an example of the present application.

### Reference list:

- 101: sapphire substrate
- 102: gallium nitride film
- 103: transfer substrate
- 104: temporary bonding layer
- 105: receiving substrate
- 106: first metal grid
- 107: second metal grid
- 108: gallium nitride epitaxial layer

### DETAILED DESCRIPTION

The embodiment of the present application is illustrated by the following specific examples, and those skilled in the art can easily understand other advantages and efficacies of the present application by the content disclosed in this specification. The present application may also be implemented or applied by other different specific embodiments, and based on different views and applications, the details in this specification may also be modified or changed without deviating from the spirit of the present application.

In detailing examples of the present application, for illustrative purposes, the cutaway view showing the device structure will not be partially enlarged according to the general proportion, and the schematic diagram is only an example, which should not limit the protection scope of the present application. In addition, in actual production, three spatial dimensions of length, width and depth should be comprised.

For ease of description, spatial relationship terms such as "under", "below", "lower than", "underneath", "above", "up", etc. may be used herein to describe the relationship of one component or feature and other components or features shown in the drawings. It should be understood that these spatial relationship terms comprise other orientation of the device in use or operation in addition to the orientation described in the drawings. Furthermore, when a layer is described as being "between" two layers, it can be the only layer between the two layers, or can be one or more layers between the two layers.

In the context of the present application, the structure where the first feature is "above" the second feature can comprise examples where the first feature directly contacts with the second feature, or can comprise examples where an additional feature forms between the first feature and the second feature, such that the first feature may not be in direct contact with the second feature.

It should be noted that the drawings provided in the example only illustrate the basic idea of the present application in a schematic manner, so the drawings only show the relevant components of the present application and are not drawn according to the number, shape and size of the components in the actual implementation, the shape, number and proportion of each component in actual implementation can be optionally changed, and the component configuration can also be more complex

As shown in FIGS. 1-9, this example provides a method for manufacturing a free-standing gallium nitride substrate, and the manufacturing method comprises the following steps.

As shown in FIG. 1, step (1) is first performed, and a composite substrate is provided, where the composite substrate comprises a sapphire substrate 101 and a gallium nitride film 102 formed on the sapphire substrate 101; in one example, the gallium nitride film 102 has a thickness of 4.5 µm.

As shown in FIG. 2, then step (2) is performed, a temporary bonding layer 104 is formed on the gallium nitride film 102; and step (3) is performed, a transfer substrate 103 is provided, and the transfer substrate 103 is bonded to the composite substrate by the temporary bonding layer 104.

In one embodiment, a temporary bonding layer 104 is formed on the gallium nitride film 102 by spin coating process in step (2), and the temporary bonding layer 104 comprises one of an epoxy resin and a high-temperature wax. For example, a melting temperature of the high-temperature wax can be more than 100°C, which is a viscous solid at less than or equal to 100°C, and when the temperature is more than the melting temperature, the high-temperature wax will partially or fully melt or be decomposed and carbonized to lose viscidity.

In one example, a material of the transfer substrate 103 comprises one of sapphire, silicon and quartz. For example, in this example, a material of the transfer substrate 103 can be sapphire. The transfer substrate 103 has exactly the same shape and size as the sapphire substrate 101.

As shown in FIG. 3, then step (4) is performed, the sapphire substrate 101 is detached by laser lift-off process, the gallium nitride film 102 is exposed, and the exposed surface of the gallium nitride film 102 is N polar.

In one example, a laser irradiates from the sapphire substrate 101 side, thereby detaching the sapphire substrate 101 from the gallium nitride film 102.

In one example, step (4) further comprises that the exposed surface of gallium nitride film 102 is subjected to acid pickling to remove remained metal gallium on the surface of the gallium nitride film 102.

As shown in FIGS. 4-6, then step (5) is performed, a receiving substrate 105 is provided, the receiving substrate 105 and the gallium nitride film 102 is subjected to weak bonding, and at the same time, the temporary bonding layer 104 is invalidated to detach the transfer substrate 103 from the gallium nitride film 102.

In one example, step (5) comprises:
as shown in FIG. 4, step (5-1) is first performed, and a first metal grid 106 is formed on the surface of the receiving substrate 105.

Specifically, forming the first metal grid 106 on the surface of the receiving substrate 105 comprises: firstly, a photoresist layer is formed on the surface of the receiving substrate 105 by spin coating process, and then a grid-grooved photolithographic pattern is formed on the receiving substrate 105 by exposure and development; subsequently, a first metal cover is formed on the surfaces of the receiving substrate 105 and the photolithographic pattern by evaporation deposition, and the first metal grid 106, a raised structure, is formed by metal lift-off process, where the photolithographic pattern and the metal cover on it are simultaneously removed.

In one example, a temperature of the bonding process is lower than a melting temperature of the first metal grid 106. For example, a material of the first metal grid 106 comprises one of Ti, Cr and Mo.

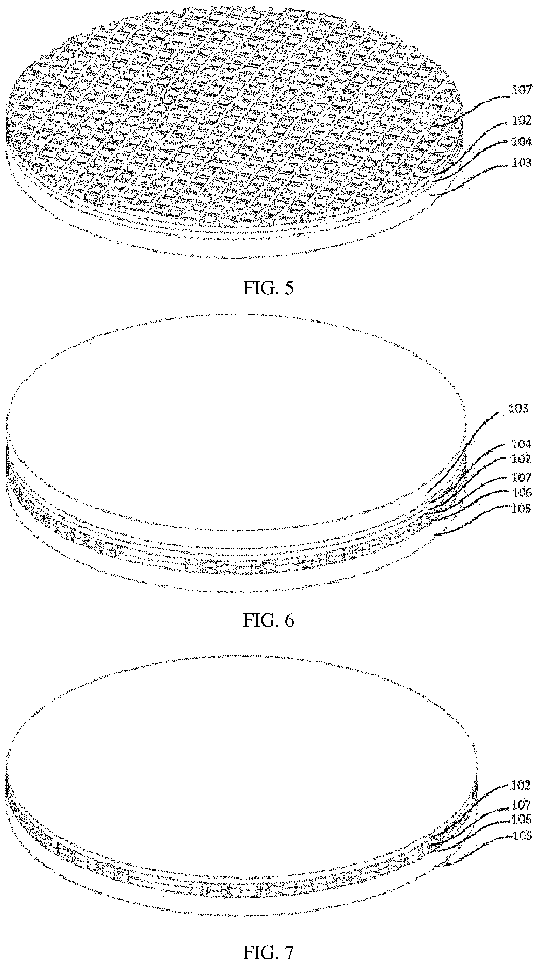

As shown in FIG. 5, then step (5-2) is performed, and a second metal grid 107 is formed on the surface of the gallium nitride film 102.

Specifically, forming the second metal grid 107 on the surface of the gallium nitride film 102 comprises: firstly, a photoresist layer is formed on the surface of the gallium nitride film 102 by spin coating process, and then a grid-grooved photolithographic pattern is formed on the gallium nitride film 102 by exposure and development; a second metal cover is formed on the surfaces of the gallium nitride film 102 and the photolithographic pattern by evaporation deposition, and the second metal grid 107, a raised structure, is formed by metal lift-off process, where the photolithographic pattern and the metal cover on it are simultaneously removed.

In one example, a temperature of the bonding process is lower than a melting temperature of the second metal grid 107. For example, a material of the second metal grid 107 comprises one of Ti, Cr and Mo.

The materials of the metal grid 106 and the metal grid 107 can be the same or different.

As shown in FIG. 6, step (5-3) is finally performed, the first metal grid 106 and the second metal grid 107 are stacked, and then the first metal grid 106 and the second metal grid 107 are diffused to each other by bonding process, so that the receiving substrate 105 is weakly bonded with the gallium nitride film 102; meanwhile, the bonding process invalidate the temporary bonding layer 104 and thereby detaches the transfer substrate 103 from the gallium nitride film 102.

For example, in one example, the temporary bonding layer 104 can be a high-temperature wax, which is a viscous solid at less than or equal to 100°C. When the temperature is higher than the melting temperature, the high-temperature wax will partially or fully melt or be decomposed and carbonized to lose viscidity. On one hand, the bonding temperature is lower than the melting temperatures of the first metal grid 106 and the second metal grid 107, which avoids too high bonding strength caused by the mutual dissolution of the first metal grid 106 and the second metal grid 107, and at the bonding temperature, the first metal grid 106 and the second metal grid 107 are only diffused to each other in solid state to realize weak bonding; on the other hand, the bonding temperature is higher than the melting temperature of the high-temperature wax to invalidate it accordingly, for example, carbonize the high-temperature wax, thereby separate the transfer substrate 103 and the gallium nitride film 102. This solution requires no additional detaching step of the transfer substrate 103, greatly reduces the process time and process cost.

As shown in FIGS. 7-9, step (6) is finally performed, a gallium nitride epitaxial layer 108 epitaxially grows on the gallium nitride film 102, and after the gallium nitride epitaxial layer 108 grows to a certain thickness, the weak bonding between the gallium nitride film 102 and the receiving substrate 105 is invalidated by the lattice mismatch stress and the thermal mismatch stress between the receiving substrate 105 and the gallium nitride film 102 as well as the gallium nitride epitaxial layer 108, so as to separate the gallium nitride film 102 and the receiving substrate 105, and the free-standing gallium nitride substrate is obtained.

In one example, the first metal grid 106 has a same shape and size as the second metal grid 107, and when the receiving substrate 105 is bonded with the gallium nitride film 102, the first metal grid 106 is aligned with the second metal grid 107. In the bonding process, it can be guaranteed that the diffusion bonding only occurs between the metals on the top surface of the photolithographic pattern, so that the connection strength of the receiving substrate 105 and the gallium nitride film 102 is weak. Meanwhile, because the metal grid has a certain height, a cavity may be formed between the metal grids after the bonding process, which thus can impair the constraint from the lattice of the receiving substrate 105 on the growth of the gallium nitride epitaxial layer 108 during the hydride vapor phase epitaxy process, so that the gallium nitride epitaxial layer 108 can grow thicker, and at a certain thickness, the lattice mismatch stress and thermal mismatch stress are used to break the weak bonding between the gallium nitride film 102 and the receiving substrate 105, and realize the separation of the gallium nitride film 102 and the receiving substrate 105. This solution can automatically separate the gallium nitride film 102 and the substrate 105, greatly reduce the process cost.

In one example, the gallium nitride epitaxial layer 108 epitaxially grows on the gallium nitride film 102 by hydride vapor phase epitaxy process in step (6).

In one example, grinding or/and cleaning the gallium nitride epitaxial layer 108 is further comprised to obtain the gallium nitride epitaxial layer 108 with a good surface quality, and thereby the high-quality free-standing gallium nitride substrate is obtained.

As described above, the method for manufacturing a free-standing gallium nitride substrate provided by examples of the present application has the following beneficial effects.

In the examples of the present application, by the application of the receiving substrate 105 and the metal grids, the bonding between the sapphire substrate 101 and the gallium nitride epitaxial layer 108 is changed from the original strong chemical bonding to a weak bonding realized by the metal grids, so that the gallium nitride film 102 is weakly bonded to the receiving substrate 105, thereby weaken the constraint from the lattice of the receiving substrate 105 on the growth of the gallium nitride epitaxial layer 108 during the hydride vapor phase epitaxy process, and the gallium nitride epitaxial layer 108 can grow thicker, and at a certain thickness, the lattice mismatch stress and thermal mismatch stress are used to break the weak bonding between the gallium nitride film 102 and the receiving substrate 105, and realize the separation of the gallium nitride epitaxial layer 108 and the receiving substrate 105. The thick gallium nitride epitaxial layer 108 can be obtained by only one epitaxial growth.

Therefore, the examples of the present application effectively overcome various shortcomings in the related art and have high industrial utilization value.

### Example 1

As shown in FIGS. 1-9, this example provides a method for manufacturing a free-standing gallium nitride substrate, and the manufacturing method comprises the following steps.

As shown in FIG. 1, step (1) was first performed, and a composite substrate was provided, where the composite substrate comprised a sapphire substrate 101 and a gallium nitride film 102 formed on the sapphire substrate 101, and the gallium nitride film 102 had a thickness of 4.5 µm.

As shown in FIG. 2, then step (2) was performed, a temporary bonding layer 104 was formed on the gallium nitride film 102; and step (3) was performed, a transfer substrate 103 was provided, and the transfer substrate 103 was bonded to the composite substrate by the temporary bonding layer 104.

A temporary bonding layer 104 was form on the gallium nitride film 102 by spin coating process in step (2), and the temporary bonding layer 104 was a high-temperature wax. A melting temperature of the high-temperature wax is more than 100°C, which is a viscous solid at less than or equal to 100°C, and when the temperature is more than the melting temperature, the high-temperature wax will partially or fully melt or be decomposed and carbonized to lose viscidity.

A material of the transfer substrate 103 was a sapphire. A shape and a size of the transfer substrate 103 were exactly the same as the sapphire substrate 101.

As shown in FIG. 3, then step (4) was performed, the sapphire substrate 101 was detached by laser lift-off process, the gallium nitride film 102 was exposed, and the exposed surface of the gallium nitride film 102 was N side.

A laser irradiated from the sapphire substrate 101 side, thereby detaching the sapphire substrate 101 from the gallium nitride film 102.

Step (4) further comprised that the exposed surface of gallium nitride film 102 was subjected to acid pickling and soaked for 30 s in a mixture of HCl:H₂O = 1:1 to remove remained metal gallium on the surface of the gallium nitride film 102.

As shown in FIGS. 4-6, then step (5) was performed, a receiving substrate 105 was provided, the receiving substrate 105 and the gallium nitride film 102 were subjected to weak bonding, and the temporary bonding layer 104 was invalidated to detach the transfer substrate 103 from the gallium nitride film 102.

Step (5) comprised: as shown in FIG. 4, step (5-1) was first performed, and a first metal grid 106 was formed on the surface of the receiving substrate 105.

Specifically, forming the first metal grid 106 on the surface of the receiving substrate 105 comprised: firstly, a photoresist layer was formed on the surface of the receiving substrate 105 by spin coating process, and then a grid-grooved photolithographic pattern was formed on the receiving substrate 105 by exposure and development; subsequently, a first metal cover was formed on the surfaces of the receiving substrate 105 and the photolithographic pattern by evaporation deposition, and the first metal grid 106, a raised structure, was formed by metal lift-off process, where the photolithographic pattern and the metal cover on it were simultaneously removed.

A temperature of the bonding process was 400°C, which was lower than a melting temperature of the first metal grid 106. A material of the first metal grid 106 was Ti.

As shown in FIG. 5, then step (5-2) was performed, and a second metal grid 107 was formed on the surface of the gallium nitride film 102.

Specifically, forming the second metal grid 107 on the surface of the gallium nitride film 102 comprised: firstly, a photoresist layer was formed on the surface of the gallium nitride film 102 by spin coating process, and then a grid-grooved photolithographic pattern was formed on the gallium nitride film 102 by exposure and development; a second metal cover was formed on the surfaces of the gallium nitride film 102 and the photolithographic pattern by evaporation deposition, and the second metal grid 107, a raised structure, was formed by metal lift-off process, where the lithographic pattern and the metal cover on it were simultaneously removed.

A temperature of the bonding process was 400°C, which was lower than a melting temperature of the second metal grid 107. A material of the second metal grid 107 was Ti.

As shown in FIG. 6, step (5-3) was finally performed, the first metal grid 106 and the second metal grid 107 were stacked, and then the first metal grid 106 and the second metal grid 107 were diffused to each other by the bonding process, so that the receiving substrate 105 was weakly bonded with the gallium nitride film 102; meanwhile, the bonding process invalidate the temporary bonding layer 104, and thereby detached the transfer substrate 103 from the gallium nitride film 102.

The temporary bonding layer 104 was a high-temperature wax, which was a viscous solid at less than or equal to 100°C. When the temperature is higher than the melting temperature, the high-temperature wax will partially or fully melt or be decomposed and carbonized to lose viscidity. On the one hand, the bonding temperature of 400°C is lower than the melting temperatures of the first metal grid 106 and the second metal grid 107, which avoids too high bonding strength caused by the mutual dissolution of the first metal grid 106 and the second metal grid 107, and at the bonding temperature, the first metal grid 106 and the second metal grid 107 are only diffused to each other in solid state to realize weak connection; on the other hand, the bonding temperature of 400°C is higher than the melting temperature of the high-temperature wax to invalidate it accordingly, thereby separate the transfer substrate 103 and the gallium nitride film 102. This solution requires no additional detaching step of the transfer substrate 103, greatly reduce the process time and process cost.

As shown in FIGS. 7-9, step (6) was finally performed, the gallium nitride epitaxial layer 108 epitaxially grew on the gallium nitride film 102, and after the gallium nitride epitaxial layer 108 grew to a certain thickness, the weak bonding between the gallium nitride film 102 and the gallium nitride epitaxial layer 108 was invalidated by the lattice mismatch stress and the thermal mismatch stress between the receiving substrate 105 and the gallium nitride film 102 as well as the gallium nitride epitaxial layer 108, so as to separate the gallium nitride film 102 and the receiving substrate 105, and the free-standing gallium nitride substrate was obtained. A thickness of the final free-standing gallium nitride substrate obtained was about 500 µm by measurement.

The first metal grid 106 had a same shape and size as the second metal grid 107, and when the receiving substrate 105 was bonded with the gallium nitride film 102, the first metal grid 106 was aligned with the second metal grid 107. In the bonding process, it can be guaranteed that the diffusion bonding only occurs between the metals on the top surface of the photolithographic pattern, so that the connection strength of the receiving substrate 105 and the gallium nitride film 102 is weak. Meanwhile, because the metal grid has a certain height, a cavity may be formed between the metal grids after the bonding process, which thus can impair the constraint from the lattice of the receiving substrate 105 on the growth of the gallium nitride epitaxial layer 108 during the hydride vapor phase epitaxy process, so that the gallium nitride epitaxial layer 108 can grow thicker, and at a certain thickness, the lattice mismatch stress and thermal mismatch stress are used to break the weak bonding between the gallium nitride film 102 and the receiving substrate 105, and realize the separation of the gallium nitride film 102 and the receiving substrate 105. This solution can automatically separate the gallium nitride film 102 and the substrate 105, greatly reduce the process cost.

The gallium nitride epitaxial layer 108 epitaxially grew on the gallium nitride film 102 by hydride vapor phase epitaxy process in step (6).

In this example, grinding or/and cleaning the gallium nitride epitaxial layer 108 was further comprised to obtain the gallium nitride epitaxial layer 108 with a good surface quality, and the high-quality free-standing gallium nitride substrate was obtained.

The above examples only illustrate the principle and efficacy of the present application and do not limit the present application. The above examples may be modified or changed by anyone familiar with this technology under the spirit and scope of the present application. Therefore, all equivalent modifications or changes, which are done by a person with ordinary knowledge in the technical field without departing from the spirit and technical ideas disclosed in the present application, shall fall within the scope of the claims of the present application

## Claims

1. A method for manufacturing a free-standing gallium nitride substrate, comprising:
(1) providing a composite substrate, wherein the composite substrate comprises a sapphire substrate and a gallium nitride film formed on the sapphire substrate;
(2) forming a temporary bonding layer on the gallium nitride film;
(3) providing a transfer substrate, and bonding the transfer substrate to the composite substrate by the temporary bonding layer;
(4) detaching the sapphire substrate by laser lift-off process to expose the gallium nitride film;
(5) providing a receiving substrate, and subjecting the receiving substrate and the gallium nitride film to weak bonding, and invalidating the temporary bonding layer to detach the transfer substrate from the gallium nitride film; and
(6) epitaxially growing a gallium nitride epitaxial layer on the gallium nitride film, and after the gallium nitride epitaxial layer grows to a certain thickness, invalidating the weak bonding between the gallium nitride film and the receiving substrate by the lattice mismatch stress and the thermal mismatch stress between the receiving substrate and the gallium nitride film as well as the gallium nitride epitaxial layer, so as to separate the gallium nitride film from the receiving substrate to obtain the free-standing gallium nitride substrate.

2. The method for manufacturing a free-standing gallium nitride substrate according to claim 1, wherein step (5) comprises: forming a first metal grid on the surface of the receiving substrate, forming a second metal grid on the surface of the gallium nitride film, and stacking the first metal grid and the second metal grid and then enabling them to diffuse to each other by bonding process to subject the receiving substrate and the gallium nitride film to weak bonding, and meanwhile, invalidating the temporary bonding layer by the bonding process to detach the transfer substrate from the gallium nitride film.

3. The method for manufacturing a free-standing gallium nitride substrate according to claim 2, wherein a temperature of the bonding process is lower than melting temperatures of the first metal grid and the second metal grid.

4. The method for manufacturing a free-standing gallium nitride substrate according to claim 2, wherein a material of the first metal grid comprises one of Ti, Cr and Mo, and a material of the second metal grid comprises one of Ti, Cr and Mo.

5. The method for manufacturing a free-standing gallium nitride substrate according to claim 2, wherein forming the first metal grid on the surface of the receiving substrate comprises:
forming a photoresist layer on the surface of the receiving substrate, and forming a grid-grooved photolithographic pattern on the receiving substrate by exposure and development; and
forming the first metal grid on the surface of the receiving substrate by evaporation deposition and metal lift-off process;
and forming the second metal grid on the surface of the gallium nitride film comprises:
forming a photoresist layer on the surface of the gallium nitride film, and forming a grid-grooved photolithographic pattern on the gallium nitride film by exposure and development; and
forming the second metal grid on the surface of the gallium nitride film by evaporation deposition and metal lift-off process.

6. The method for manufacturing a free-standing gallium nitride substrate according to claim 2, wherein the first metal grid has a same shape and size as the second metal grid, and when the receiving substrate is bonded with the gallium nitride film, the first metal grid is aligned with the second metal grid.

7. The method for manufacturing a free-standing gallium nitride substrate according to claim 1, wherein the temporary bonding layer is formed on the gallium nitride film by spin coating process in step (2), and the temporary bonding layer comprises one of an epoxy resin and a high-temperature wax.

8. The method for manufacturing a free-standing gallium nitride substrate according to claim 1, wherein a material of the transfer substrate and the receiving substrate comprises one of sapphire, silicon and quartz.

9. The method for manufacturing a free-standing gallium nitride substrate according to claim 1, wherein step (4) further comprises performing acid pickling on the exposed surface of the gallium nitride film to remove remained metal gallium on the surface of the gallium nitride film.

10. The method for manufacturing a free-standing gallium nitride substrate according to claim 1, wherein the gallium nitride epitaxial layer is epitaxially grown on the gallium nitride film by hydride vapor phase epitaxy process in step (6).
